(19) Europäisches Patentamt
European Patent Office
Office européen des brevets

(11) EP 1 489 752 A1

(12) EUROPEAN PATENT APPLICATION
published in accordance with Art. 158(3) EPC

(43) Date of publication:
22.12.2004 Bulletin 2004/52

(51) Int Cl.7: H04B 1/30, H03H 19/00

(21) Application number: 03708663.4

(86) International application number:
PCT/JP2003/003274

(22) Date of filing: 18.03.2003

(87) International publication number:
WO 2003/084085 (09.10.2003 Gazette 2003/41)

(84) Designated Contracting States:
DE FR GB NL

(30) Priority: 28.03.2002 JP 2002091835

(71) Applicants:
• Kabushiki Kaisha Toyota Jidoshokki
Kariya-shi, Aichi-ken 448-8671 (JP)
• Niigata Seimitsu Co., Ltd.
Niigata 943-0834 (JP)

(72) Inventor: MIYAGI, Hiroshi
c/o NIIGATA SEIMITSU CO., LTD.
Joetsu-shi, Niigata 943-0834 (JP)

(74) Representative: Vollnhals, Aurel
Tiedtke-Bühling-Kinne & Partner (GbR),
TBK-Patent,
Bavariaring 4
80336 München (DE)

(54) RECEIVER APPARATUS

(57) A receiver (11) converts a received signal directly to a baseband signal, and includes: a switched-capacitor filter (19) controlling a cutoff frequency when the baseband signal is filtered according to a control signal provided for a switched-capacitor element (27); an oscillator generating a periodic signal; and a divider (31) dividing a periodic signal generated by the oscillator according to the received signal, and an output signal from the divider (31) is provided as the control signal for the switched-capacitor element (27).

F I G. 1

EP 1 489 752 A1

## Description

### Technical Field

The present invention relates to a receiver for receiving various signal bands such as the signal bands of a mobile telephone, a radio, etc.

### Background Art

Generally, a system for receiving various radio bands of signals such as a mobile telephone, a radio, etc. can be a superheterodyne system, a direct conversion system, etc. In the superheterodyne system among various systems, a received signal is temporarily converted to a signal of an intermediate frequency, and then converted to a baseband signal.

When signals of various frequency bands are received in a receiver using the superheterodyne system, it is necessary for the receiver to process a broadband signal for signal processing of an intermediate frequency signal depending on the received signal.

That is, for example, in the case of a receiver in the superheterodyne system for receiving an AM signal and an FM signal in Japan, the receiver requires a band pass filter for a broad signal bands to pass through the two intermediate frequency band for receiving both AM and FM signals. The receiver for processing these plurality of intermediate frequency signals has the problem of a complicated configuration and a large size.

A direct conversion system has been well known as a receiving system having a simple configuration and a small size.

The direct conversion system converts a received signal directly to a baseband signal by mixing a received signal with a signal having the same frequency as the received signal. The receiver in the direct conversion system does not use an intermediate frequency, but converts a received signal directly to a baseband signal, thereby requiring no filter for removing an image signal for use in an RF (radio frequency) circuit unit, and realizing a small receiver. Thus, the direct conversion system has attracted attention as a receiving system capable of realizing a small receiver.

However, when received signals of various frequency bands are received, the receiver in the direct conversion system, the receiver has to process signals of a broad band to process a baseband signal depending on the received signal.

That is, in the receiver in the conventional direct conversion system, it has been necessary to prepare a filter for removing an unnecessary signal for each signal band depending on each signal band.

It is necessary to switch these filters depending on each signal band. The control circuit for switching the filters has a complicated configuration with an increasing number of signal bands, thereby causing a large receiver.

Additionally, a conventional receiver configures a filter by a passive element of a resistor and a capacitor, and has a problem of large variance of filter characteristic.

Thus, the present invention has been developed to solve the above-mentioned problems, and aims at providing a receiver capable of being easily applied to various signal bands, and suitable for semiconductor integration.

### Disclosure of Invention

The receiver according to the first aspect of the present invention is a receiver for converting a received signal directly to a baseband signal, and includes: a switched-capacitor filter for controlling the cutoff frequency when the baseband signal is filtered according to the control signal provided for a switched-capacitor element, an oscillator for generating a periodic signal, and a divider for dividing a periodic signal generated by the oscillator according to the received signal. An output signal from the divider is provided as a control signal for the switched-capacitor element.

With the above-mentioned configuration, a switched-capacitor filter is used as a frequency filter for passing a baseband signal. Therefore, various received signal bands can be supported only by varying the cutoff frequency of the switched-capacitor filter, thereby removing the filtering process for each receiving band. Thus, a smaller receiver can be realized.

In the receiver according to the second aspect of the present invention, the first divider is a programmable counter and can be configured by a divider in the system of a division to an integral multiple or the fractional-N system.

With the above-mentioned configuration, an arbitrary cutoff frequency can be set, and various receiving bands can be supported.

In the receiver according to the third aspect of the present invention, the switched-capacitor filter includes at least an amplifier, and a resistor element as a feedback resistor of the amplifier can be realized by the switched-capacitor element.

With the above-mentioned configuration, the operation and the effect similar to those of the first aspect can be obtained.

The receiver according to the fourth aspect of the present invention is a receiver for converting a received signal directly to a baseband signal, and includes an oscillator for generating a periodic signal, a mixer for mixing a periodic signal generated by the oscillator with the received signal, and outputting a baseband signal, a switched-capacitor filter for controlling the cutoff frequency when filtering the baseband signal output from the mixer according to the control signal provided for the switched-capacitor element, and a divider for dividing a periodic signal generated by the oscillator according to the received signal, and the output signal from the divider is provided as the control signal for the switched-capacitor element.

With the above-mentioned configuration, the signal output from the voltage control oscillator is divided by a divider such as a programmable counter, etc., and the passband of the switched-capacitor filter is varied using the divided signal. Therefore, a circuit for generating a reference frequency signal required to vary the passband of a switched-capacitor filter can be omitted, thereby realizing a smaller receiver.

**Brief Description of Drawings**

The present invention will become more apparent by reference to the following detailed description of the invention taken in conjunction with the accompanying drawings, wherein:

FIG. 1 shows a receiver according to the present invention;
FIG. 2A shows the configuration of the circuit of the switched-capacitor filter;
FIG. 2B shows the relationship between the cutoff frequency in the switched-capacitor filter and the resistance of the feedback resistor in the primary integral active LPF;
FIG. 2C shows the switched-capacitor element;
FIG. 3A shows the control operation of the switching operation of the switched-capacitor element;
FIG. 3B shows the divider in the fractional-N system; and
FIG. 4 shows the configuration of the synthesizer in the PLL system for varying the frequency of an oscillation signal output from the local oscillator.

**Best Mode for Carrying Out the Invention**

The embodiments of the present invention are described below by referring to the attached drawings.

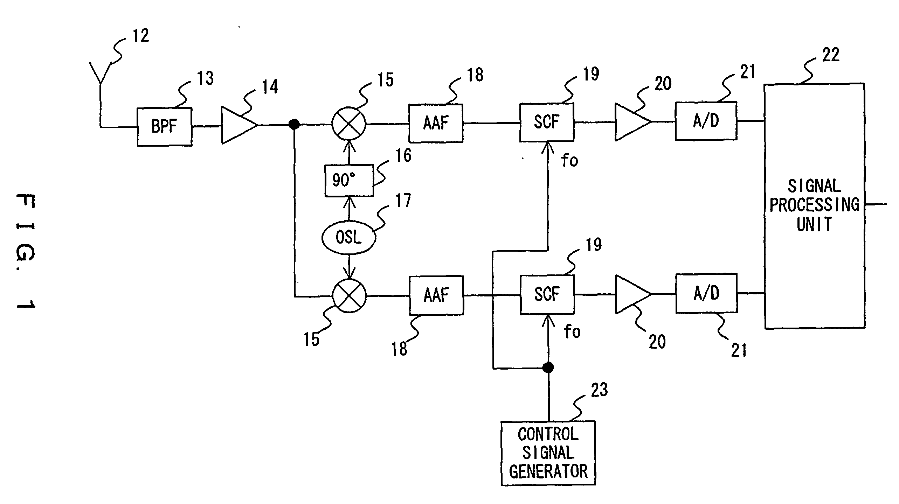

FIG. 1 shows the receiver of the present invention.

FIG. 1 shows a direct conversion receiver 11, an antenna 12, a band pass filter 13, a high-frequency signal amplifier 14, a mixer 15, a 90° phase-shifter 16, a local oscillator 17, an anti-aliasing filter 18, a switched-capacitor filter 19, a baseband signal amplifier 20, an A/D converter 21, a signal processing unit 22, and a control signal generator 23.

The signal processing unit 22 is shown as one function block, and performs various processes (for example, a detecting process, a digital filter processing, etc.) after conversion of a received signal to a baseband signal.

In FIG. 1, when a received signal is converted to a baseband signal and the subsequent processes are performed with an analog signal, the A/D converter 21 is omitted.

The switched-capacitor filter 19 has the function of a low pass filter for removing the high-frequency element of the baseband signal, and the cutoff frequency can be varied depending on the control signal output from the control signal generator 23.

The direct conversion receiver 11 can be integrated on one chip.

The operations of the direct conversion receiver 11 are explained below.

First, when the direct conversion receiver 11 receives a received signal from the antenna 12, it removes an unnecessary signal using the band pass filter 13, and amplifies the received signal using the high-frequency signal amplifier 14.

The amplified received signal is converted to a two orthogonal signal having phases different by 90° by the mixer 15, the 90° phase-shifter 16, and the local oscillator 17. The signal input from the local oscillator 17 to the mixer 15 has the same frequency as the received signal.

An excess signal is removed from the two orthogonal signals by the anti-aliasing filter 18 to protect them against the folding noise generated in the subsequent process, and the signals are then inputted to the switched-capacitor filter 19.

The high-frequency element is removed by the switched-capacitor filter 19 from the signals input to the switched-capacitor filter 19, and the resultant signals are amplified by the baseband signal amplifier 20.

The signal amplified by the baseband signal amplifier 20 is converted to a digital signal by the A/D converter 21, and is treated in the signal processing unit 22 by a predetermined digital filter processing such as a detecting process, etc.

When a received signal is converted directly to a baseband signal, the direct conversion receiver 11 removes the unnecessary signal (an image signal, etc.) generated in the received signal by a low pass filter.

At this time, it is necessary to change the passband of the low pass filter depending on the signal band of the received signal. In the direct conversion receiver 11 of the present embodiment, the switched-capacitor filter 19 is used as a low pass filter to change the passband for each signal band.

Thus, as a conventional receiver, a filter is prepared for each signal band, it is not necessary to perform the process of switching a filter depending on the signal band of a received signal, and a simple circuit configuration can be realized.

That is, one switched-capacitor filter 19 can process a received signal of a desired signal band among a plurality of signal bands by providing the switched-capacitor filter 19 having the low pass filter function and the function of changing a cutoff frequency in the direct conversion receiver 11. Thus, the direct conversion receiver 11 can be downsized.

Described below is the circuit configuration of the switched-capacitor filter 19.

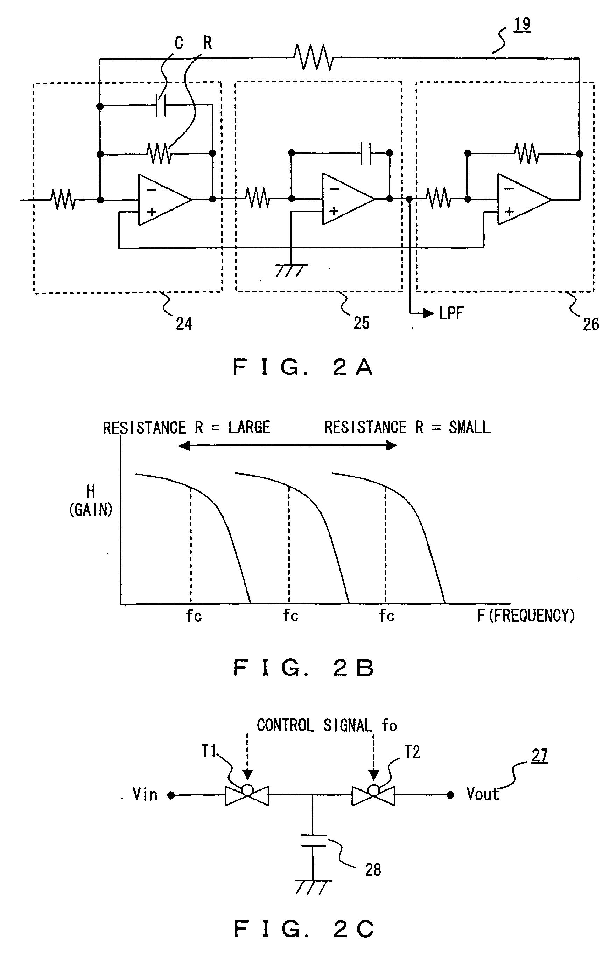

FIG. 2A shows the circuit configuration of the switched-capacitor filter 19.

In FIG. 2A, the switched-capacitor filter 19 is a well-known status-variable active LPF (low pass filter) (or a bi-quad low pass filter).

In the switched-capacitor filter 19, an integrator 25 and an inverse amplifier 26 are added to a secondary bi-quad active LPF 24 in which resistors are connected in series to the input terminal of the op-amp, thereby configuring a closed loop. The output of the integrator 25 of the switched-capacitor filter 19 has the function similar to that of the output of the low pass filter of the conventional receiver.

Normally, the 3dB falling-pass bandwidth $\omega$ in the switched-capacitor filter 19 holds the following equation.

$$\omega = 1/RC - \tag{1}$$

where R and C respectively indicate the resistance of a feedback resistor and the capacitance of a capacitor of the secondary bi-quad active LPF 24.

The switched-capacitor filter 19 raises the cutoff frequency fc when the 3dB falling-pass bandwidth $\omega$ increases, and reduces the cutoff frequency fc when the 3dB falling-pass bandwidth $\omega$ decreases.

FIG. 2B shows the relationship between the cutoff frequency fc in the switched-capacitor filter 19 and the resistance of the feedback resistor R in the primary integral active LPF 24.

As shown in FIG. 2B, when a high cutoff frequency fc is to be set, the resistance of the feedback resistor R in the secondary bi-quad active LPF 24 is set small. When a low cutoff frequency fc is to be set, the resistance of the feedback resistor R in the primary integral active LPF 24 is set large.

Thus, when the cutoff frequency fc of the switched-capacitor filter 19 is varied, the resistance of the feedback resistor R of the secondary bi-quad active LPF 24 is varied.

Described below is the method for varying the resistance of the feedback resistor R in the secondary bi-quad active LPF 24.

FIG. 2C shows a switched-capacitor element 27 used as a feedback resistor R of the secondary bi-quad active LPF 24.

As shown in FIG. 2C, the switched-capacitor element 27 comprises a capacitor 28 and two switches T1 and T2, and the resistor element having the resistance depending on the control signal fo can be obtained by alternately switching the switches T1 and T2 connected to the capacitor 28 using the control signal fo. The resistance RE of the switched-capacitor element 27 is represented by $RE = 1 / (f0 \cdot C)$.

The resistance of the switched-capacitor element 27 can be varied by reducing or raising the speed of the switching operation of the switches T1 and T2.

Generally, the cutoff frequency fc of the filter formed by the capacitor C1 and the resistor R1 is represented as follows.

$$fc = 1 / (2\pi \cdot C1 \cdot R1)$$

When a common switched-capacitor filter is used, the following equation holds.

$$fc = (f0 \cdot C) / (2\pi C1)$$

In the case of the switched-capacitor filter formed by two capacitors (capacitors C and C1) on the same IC chip, the two capacitors have the capacitance in the same direction and there is variance of capacitance. Therefore, the precision of the cutoff frequency is not high.

As a result, assuming that the variance coefficient of the capacitance of the two capacitors is k, the cutoff frequency fc of the switched-capacitor filter is represented as follows.

$$\text{fc} = (\text{f0} \cdot \text{k} \cdot \text{C}) / (2\pi \cdot \text{k} \cdot \text{C1})$$

$$= (\text{f0} \cdot \text{C}) / (2\pi\text{C1})$$

Thus, the variance of the capacitance between the capacitor C and the capacitor C1 can be absorbed, and the precision of the control signal fo can be enhanced.

Described below is the method for generating a control signal fo to be input to the switches T1 and T2.

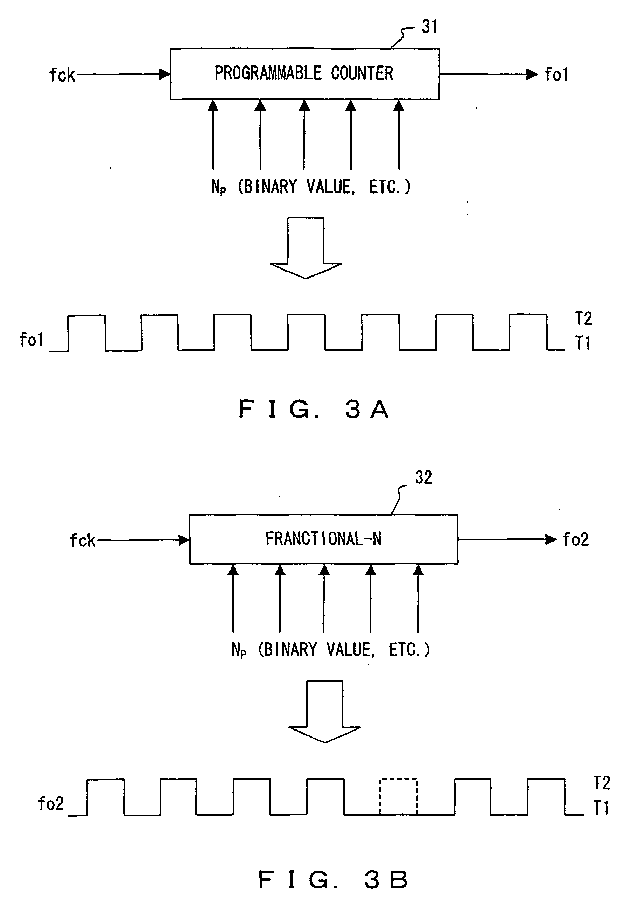

FIG. 3A is an explanatory view showing the method for generating the control signal fo to be inputted to the switches T1 and T2.

FIG. 3A shows a programmable counter 31 for inputting the frequency fck of the input signal and outputting a control signal of the frequency fol depending on the binary value Np1 (integral multiple). At this time, the control signal output from the programmable counter 31 is output based on the signal band of the received signal.

That is, the reference signal fck input to the programmable counter 31 is divided into the signal of fo1 = fck/Np1 depending on the signal band of a received signal, and fo1 controls the switching operation of the switched-capacitor filter 19 as a control signal.

For example, relating to the control signal fo1 output from the programmable counter 31, the switch T1 is closed (the switch T1 is turned ON) and the switch T2 is open (the switch T1 is turned OFF) when the control signal fo1 is at the H (high) level. Thus, the electric charge is stored in the capacitor 28.

When the control signal fol is at the L (low) level, the switch T1 is open (the switch T1 is turned OFF) and the switch T2 is closed (the switch T2 is turned ON). thus, the charge stored in the capacitor 28 is discharged to the switch T2.

By increasing the speed of the ON/OFF switching operation on the switches T1 and T2, the resistance of the switched-capacitor element 27 as the feedback resistor R is reduced.

On the other hand, by reducing the ON/OFF switching operation, the resistance' of the switched-capacitor element 27 as the feedback resistor R is increased.

Described below is the case in which received signal of a different signal band is received.

The switched-capacitor filter 19 has to vary the cutoff frequency for each different signal band. To set a lower cutoff frequency, the frequency of the control signal fo input to the switched-capacitor element 27 is reduced to increase the resistance R based on the above-mentioned $\omega = 1 / RC$ - (1). At this time, the binary value for output of the control signal fo of a low frequency from the programmable counter 31 is input to the programmable counter 31.

On the other hand, to set a higher cutoff frequency, the frequency of the control signal fo input to the switched-capacitor element 27 is raised to reduce the resistance R based on the above-mentioned $\omega = 1/RC$ - (1). At this time, the binary value for output of the control signal fo of a high frequency from the programmable counter 31 is input to the programmable counter 31.

Thus, by varying the speed of the ON/OFF switching operation on the switches T1 and T2 according to the control signal fol output by the programmable counter 31, the resistance of the switched-capacitor element 27 can be changed. By varying the resistance of the switched-capacitor element 27, the cutoff frequency fc of the switched-capacitor filter 19 can be varied.

FIG. 3B shows the divider of the fractional-N (fractional number) system.

In FIG. 3B, a divider 32 of the fractional-N system has a division value including decimal places, and a desired division ratio, which is not limited to 1/N, can be arbitrarily set.

The programmable counter 31 determines the division ratio depending on the value of the integral multiple of the reference signal, but the divider 32 in the fractional-N system can arbitrarily set the division ratio by reducing or adding the pulse of the input reference signal fck.

The switching operation of the switched-capacitor element 27 is controlled by inputting the signal fo2 output from the divider 32 of the fractional-N system to the switched-capacitor element 27 as a control signal. Thus, by controlling the switching operation of the switched-capacitor element 27 using the signal output by the divider 32 of the fractional-N system, the control can be performed more precisely than by the programmable counter 31.

Thus, in the direct conversion receiver 11, the received signal of various signal bands can be received with a simpler configuration by using the switched-capacitor filter 19 as a low pass filter for removing an unnecessary signal of a baseband signal.

Since the switched-capacitor filter 19 can be generated in a semiconductor integrated circuit, the entire circuit can be downsized.

Furthermore, to generate a control signal for varying the cutoff frequency, the programmable counter 31 and the divider 32 of the fractional-N system are adopted and the data value is changed to change the division ratio of them, thereby easily changing the cutoff frequency.

The direct conversion receiver 11 according to the present embodiment is not limited to the above-mentioned examples.

For example, an output signal from the local oscillator 17 is divided, and the divided signal can be used as a control signal fo for varying the cutoff frequency of the switched-capacitor filter 19.

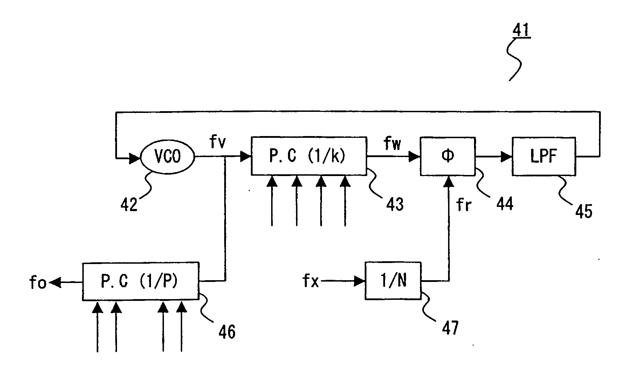

FIG. 4 shows the configuration of a synthesizer 41 of the PLL (phase locked loop) system for varying the frequency of an oscillation signal of the local oscillator 17 in the direct conversion receiver 11.

FIG. 4 shows a voltage controlled oscillator (VOC) 42, a programmable counter 43 for dividing into an integral submultiple the frequency of a signal input from the voltage controlled oscillator 42 depending on the input binary value (integral multiple), a phase comparator 44 for comparing the signal output from the programmable counter 43 with the reference signal fx and outputting a voltage value depending on the phase difference, and a low pass filter 45 for removing an unnecessary voltage element from the voltage value output from the phase comparator 44, and generals a DC control voltage.

A programmable counter 46 divides a frequency of a signal output from the voltage controlled oscillator 42 into 1/P. A divider 47 fixedly divides into 1/N the frequency of the reference signal fx output from the crystal oscillator, etc. The reference signal fr output from the divider 47 is set to fr = fx/N.

The synthesizer 41 shown in FIG. 4 is a synthesizer of the PLL system using the well-known programmable counter 43.

The phase comparator 44 compares relating to the phases the reference signal fr output from the divider 47 with the signal fw obtained by dividing the programmable counter 43 into 1/k the signal fv output from the voltage controlled oscillator 42, and outputs the voltage depending on the phase difference. Thus, the signal fv output from the voltage controlled oscillator 42 maintains the relation of fv= fr · K by the PLL loop of the synthesizer 41.

The signal fv output from the voltage controlled oscillator 42 is divided by the programmable counter 46 into 1/P, and the divided signal is used in controlling the ON/OFF switching operation on the switches T1 and T2 of the switched-capacitor element 27 in the switched-capacitor filter 19.

At this time, since the control signal output from the programmable counter 46 can also be used as an oscillation signal for conversion of a received signal to a baseband signal, the binary value input to the programmable counter 46 holds a predetermined relationship with the received signal.

The programmable counter 43 or the programmable counter 46 can be configured as a divider of the fractional-N system.

Thus, when the programmable counter 46 is a divider of the fractional-N system, the frequency of the control signal input to the switched-capacitor filter 19 can be arbitrarily set.

According to the receiver of the present invention, a switched-capacitor filter is used as a low pass filter of a receiver for converting a received signal directly to a baseband signal, and the cutoff frequency is changed. Thus, the cutoff frequency can be changed, thereby realizing a receiver of a simple configuration with the capability for various signal bands. Additionally, by using a programmable counter of the system of dividing by an integral multiple as a divider or of the fractional-N system, the cutoff frequency of the switched-capacitor filter can be set to an arbitrary frequency.

**Claims**

**1.** A receiver which converts a received signal directly to a baseband signal, comprising:

a switched-capacitor filter controlling a cutoff frequency when the baseband signal is filtered according to a control signal provided for a switched-capacitor element;
an oscillator generating a periodic signal; and
a divider dividing a periodic signal generated by said oscillator according to the received signal, **characterized in that**
an output signal from the divider is provided as the control signal for the switched-capacitor element.

**2.** The receiver according to claim 1, **characterized in that**
said divider is a programmable counter and is a divider in a system of a division to an integral multiple or a fractional-N system.

3. The receiver according to claim 1, **characterized in that**
said switched-capacitor filter comprises at least an amplifier, and a resistor element, which functions as a feedback resistor of the amplifier, is realized by the switched-capacitor element.

4. A receiver which converts a received signal directly to a baseband signal, comprising:

an oscillator generating a periodic signal;
a mixer for mixing a periodic signal generated by said oscillator with the received signal, and outputting a baseband signal;
a switched-capacitor filter controlling a cutoff frequency when filtering the baseband signal output from said mixer according to a control signal provided for a switched-capacitor element; and
a divider dividing a periodic signal generated by said oscillator according to the received signal, **characterized in that**
the output signal from said divider is provided as the control signal for the switched-capacitor element.

F I G. 1

F I G. 2 A

RESISTANCE R = LARGE          RESISTANCE R = SMALL

H (GAIN)

fc          fc          fc          F (FREQUENCY)

F I G. 2 B

CONTROL SIGNAL fo

T1          T2          27

Vin          Vout

28

F I G. 2 C

9

F I G. 3 A

F I G. 3 B

<table>
<tr><td colspan="2">**INTERNATIONAL SEARCH REPORT**</td><td>International application No.<br>PCT/JP03/03274</td></tr>
</table>

| A. CLASSIFICATION OF SUBJECT MATTER |
|---|
| Int.Cl⁷ H04B1/30, H03H19/00 |

According to International Patent Classification (IPC) or to both national classification and IPC

| B. FIELDS SEARCHED |
|---|

Minimum documentation searched (classification system followed by classification symbols)
Int.Cl⁷ H04B1/30, H03H19/00

Documentation searched other than minimum documentation to the extent that such documents are included in the fields searched

| | | | |
|---|---|---|---|
| Jitsuyo Shinan Koho | 1922–1996 | Toroku Jitsuyo Shinan Koho | 1994–2003 |
| Kokai Jitsuyo Shinan Koho | 1971–2003 | Jitsuyo Shinan Toroku Koho | 1996–2003 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| Y | JP 5-183342 A (Toshiba Corp.),<br>23 July, 1993 (23.07.93),<br>Par. No. [0006]<br>(Family: none) | 1-4 |
| Y | JP 5-283614 A (Crystal Semiconductor Corp.),<br>29 October, 1993 (29.10.93),<br>Fig. 1<br>& DE 4300519 A1 & US 5220483 A | 1-4 |
| Y | JP 2000-114896 A (NEC Corp.),<br>21 April, 2000 (21.04.00),<br>Fig. 1<br>(Family: none) | 1-4 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>20 May, 2003 (20.05.03) | Date of mailing of the international search report<br>03 June, 2003 (03.06.03) |
|---|---|
| Name and mailing address of the ISA/<br>Japanese Patent Office | Authorized officer |
| Facsimile No. | Telephone No. |

Form PCT/ISA/210 (second sheet) (July 1998)

**EP 1 489 752 A1**

## INTERNATIONAL SEARCH REPORT

| International application No. |
| --- |
| PCT/JP03/03274 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 10-215152 A   (NEC Corp.),<br>11 August, 1998 (11.08.98),<br>Fig. 2<br>(Family: none) | 2-3 |

Form PCT/ISA/210 (continuation of second sheet) (July 1998)

13